(19)

**Europäisches Patentamt**
**European Patent Office**
**Office européen des brevets**

(11) **EP 4 761 502 A1**

(12) **EUROPEAN PATENT APPLICATION**

(43) Date of publication:
**17.06.2026 Bulletin 2026/25**

(21) Application number: **24219853.9**

(22) Date of filing: **13.12.2024**

(51) International Patent Classification (IPC):
*H10D 30/01* (2025.01)      *H10D 30/83* (2025.01)
*H10D 62/17* (2025.01)      *H10D 62/60* (2025.01)

(52) Cooperative Patent Classification (CPC):
**H10D 30/831; H10D 30/0515; H10D 62/328;**
**H10D 62/60;** H10D 62/343; H10D 62/8325

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Infineon Technologies Austria AG**
**9500 Villach (AT)**

(72) Inventors:
• **POPESCU, Dan Horia**
**81245 München (DE)**
• **FISCHER, Björn**
**81547 München (DE)**
• **KAMMERLANDER, David**
**9500 Villach (AT)**
• **WEBER, Hans**
**9500 Villach (AT)**

(74) Representative: **Westphal, Mussgnug & Partner,**
**Patentanwälte mbB**
**Werinherstraße 79**
**81541 München (DE)**

(54) **METHOD FOR PRODUCING A VERTICAL JFET**

(57)      Disclosed is a method, The method includes: forming a plurality of trenches (110) in a first surface (101) of a semiconductor body (100) such that the trenches (110) are separated from each other by semiconductor mesa regions (120); and forming a channel region (13) of a first doping type in each of the mesa regions (120). Forming the channel region (13) includes implanting first type dopant atoms at least into a first sidewall (121) of the respective mesa region (120), and implanting the first type dopant atoms into the first sidewall (121) includes at least two implantation processes that are different from each other with regard to at least one process parameter.

FIG 1

EP 4 761 502 A1

**Description**

This disclosure relates in general to a method for producing a vertical JFET (Junction Field-Effect Transistor) and a vertical JFET.

A vertical JFET may include a plurality of gate trenches that each include a gate electrode and that are separated from each other by semiconductor mesa regions. Each of the mesa regions includes a source region and a channel region of a first doping type (conductivity type) and a gate region. The gate regions are of a second doping type complementary to the first doping type and are each connected to one of the gate electrodes. A JFET is a voltage-controlled transistor device that is in an on-state (conducting state) or an off-state (blocking state) dependent on a voltage (usually referred to as gate-source voltage) applied between the gate electrodes and the source regions. The JFET is in the off-state when the voltage applied between the gate electrodes and the source regions has a polarity that reverse biases PN junctions formed between the channel regions and the gate regions and a magnitude that is high enough for the channel regions to be entirely depleted of charge carriers. An N-type JFET, for example, which is a JFET in which doped regions of the first doping type are N-type regions and doped regions of the second doping type are P-type regions, is in the off-state when the gate-source voltage is more a negative than a predefined threshold voltage. In other words, an N-type JFET is in the off-state when the gate source voltage is negative and has a magnitude that is higher than the magnitude of the (negative) threshold voltage.

The threshold voltage is an essential feature of a vertical JFET. There is a need for producing a vertical JFET with a precisely defined threshold voltage.

One example relates to a method, particularly a method for producing a vertical JFET. The method includes forming a plurality of trenches in a first surface of a semiconductor body such that the trenches are separated from each other by semiconductor mesa regions, and forming a channel region of a first doping type in each of the mesa regions. Forming the channel region includes implanting first type dopant atoms at least into a first sidewall of the respective mesa region. Implanting the first type dopant atoms into the first sidewall includes at least two implantation processes that are different from each other with regard to at least one process parameter.

Examples are explained below with reference to the drawings. The drawings serve to illustrate certain principles, so that only aspects necessary for understanding these principles are illustrated. The drawings are not to scale. In the drawings the same reference characters denote like features.

Figure 1 schematically illustrates a vertical cross-sectional view of one portion of a JFET;

Figure 2 schematically illustrates semiconductor body after forming gate trenches to define mesa regions in a semiconductor layer of the semiconductor body;

Figures 3A-3B illustrate one example of a process for implanting dopant atoms in a first sidewall of a mesa region;

Figures 4A-4B illustrate one example of a process for implanting dopant atoms in a first sidewall of a mesa region;

Figure 5 schematically illustrates a vertical cross-sectional view of one gate electrode and adjoining mesa regions of a JFET;

Figure 6 illustrates a doping profile in one of the mesa regions illustrated in Figure 5 in a lateral direction; and

Figure 7 illustrates a doping profile in one of the mesa regions illustrated in Figure 5 in a vertical direction.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

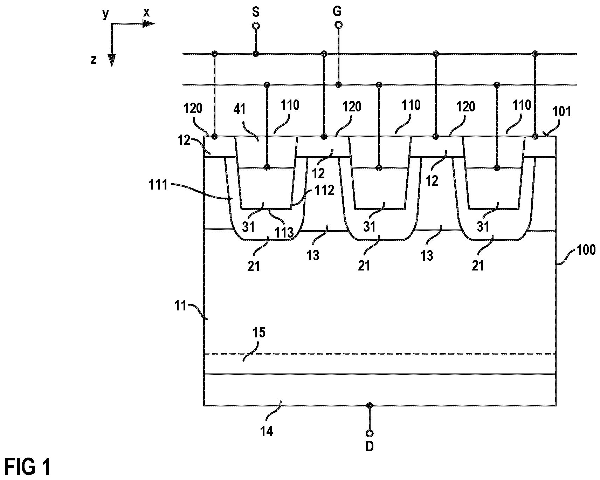

Examples explained herein further below relate to a method for forming channel regions of a vertical JFET (Junction Field-Effect Transistor). Just for the purpose of illustration, one example of a vertical JFET is illustrated in Figure 1.

Referring to Figure 1, the JFET includes a semiconductor body 100. The semiconductor body 100 includes a monocrystalline semiconductor material. The semiconductor material is silicon (Si) or silicon carbide (SiC), for example.

Referring to Figure 1, the JFET includes a plurality of gate trenches 110 that each extend from a first surface 101 of the semiconductor body 100 into the semiconductor body 100 and that are separated from each other by semiconductor mesa regions 120. According to one example, the gate trenches 110 are spaced apart from each other in a first lateral direction x of the semiconductor body 100, so that gate trenches 110 and mesa regions 120 are arranged alternatingly in the first lateral direction x.

According to one example, the gate trenches 110 are elongated in a second lateral direction y perpendicular to the first lateral direction x. According to one example, "elongated" includes that a length of the gate trenches 110, which is the dimension of the gate trenches 110 in the second lateral direction y, is much larger than a width of the gate trenches 110, which is the dimension of the gate trenches 110 in the first lateral direction x. According to one example, the length is at least 10 times, at least 100 times, or at least 1000 times the width.

A vertical direction z of the semiconductor body 100 is a direction perpendicular to the first and second lateral directions x, y. According to one example, the first surface 101 is essentially parallel to the first and second lateral directions x, y and perpendicular to the vertical direction z.

Referring to Figure 1, the JFET further includes a plurality of channel regions 13 of a first doping type (conductivity type), wherein each of the channel regions 13 is at least partially arranged in a respective one of the mesa regions 120. "A channel region being least partially arranged in a respective mesa region" includes that the channel region 13 is entirely arranged in the mesa region or that the channel region 13, in the vertical direction z, extends beyond the mesa regions 120. The latter includes that a channel region 13 is partially arranged in a mesa region 120 and, in the vertical direction z, extends beyond a vertical position of trench bottoms 113 of the two neighboring gate trenches 110 that define the respective mesa region 120.

Each channel region 13, in the vertical direction z, is arranged between a source region 12 of the first doping type and a drift region 11 of the first doping type. Each source region 12 is arranged in a respective mesa region 120 and is connected to a source node of the JFET.

Furthermore, the JFET includes a plurality of the gate regions 21 of a second doping type complementary to the first to doping type, wherein each gate region 21 adjoins the sidewalls 111, 112 and the bottom 113 of a respective gate trench 110 and is electrically connected to a gate electrode 31 arranged in the gate trench 110. The gate electrodes 31 are connected to a node G of the JFET and are electrically insulated from the source regions 12. In the example illustrated in Figure 1, the gate electrodes 31 are insulated from the source regions 12 by an insulating layer 41.

In the example illustrated in Figure 1, each channel region 13, in the first lateral direction x, is arranged between portions of two different gate regions 21. More specifically, each channel region 13 is arranged between a portion of a gate region 21 that adjoins sidewalls 111, 112 and a bottom 113 of a first trench and a portion of a gate region 21 that adjoins sidewalls 111, 112 and a bottom 113 of a second trench, wherein the first trench 110 and the second trench 110 are spaced apart from each other in the first lateral direction x and define the mesa region 120 in which the channel region 13 is arranged. A PN junction is formed between each channel region 13 and the respective gate region 21 adjoining the channel region 13.

According to one example, the JFET further includes a drain region 14 of the first doping type. The drain region 14 is spaced apart from the mesa regions 120 in the vertical direction z. The drift region 11 is arranged between the channel regions 13 and the drain region 14. Optionally, the JFET further includes a buffer region 15 of the first doping type arranged between the drift region 11 and the drain region 14. According to one example, the buffer region 15 has a doping concentration that is lower than the doping concentration of the drain region 14 and higher than the doping concentration of the drift region 11. Doping concentrations of the individual doped device regions are, for example,

drift region 11: between $1E16$ cm$^{-3}$ and $2E16$ cm$^{-3}$
drain region 15: between $5E17$ cm$^{-3}$ and $5E18$ cm$^{-3}$
source region 12: between $5E17$ cm$^{-3}$ and $5E18$ cm$^{-3}$
buffer region 14: between $2E18$ cm$^{-3}$ and $2E19$ cm$^{-3}$.

In particular the doping concentration of the drift region 11 is selected dependent on a desired voltage blocking capability of the transistor device. The higher the desired voltage blocking capability, the lower the doping concentration of the drift region, for example. According to one example, the doping concentration of the drift region 11 is $1.1E16$ cm$^{-3}$ in transistor device with a voltage blocking capability of 1200 V and $1.8E16$ cm$^{-3}$ in transistor device with a voltage blocking capability of 750 V.

The JFET illustrated in Figure 1 is a voltage-controlled transistor device that is in an on-state (conducting state) or an off-state (blocking state) dependent on a voltage (gate-source voltage) applied between the gate electrodes 31 and the source regions 12. An N-type JFET, for example, has a negative threshold voltage. An N-type JFET is a JFET in which the first doping type is an N-type, so that the channel regions 13, the source regions 12, the drift region 11, the drain region 14, and the optional buffer region 15 are N-type regions and the gate regions 21 are P-type regions. Thus, an N-type JFET is in the off-state when the gate-source voltage is more negative than the threshold voltage. In other words, an N-type JFET is in the off-state when the gate-source voltage is negative and has a magnitude that is higher than the magnitude of the (negative) threshold voltage. An N-type JFET is in the on-state when the gate-source voltage is less negative than the threshold voltage.

In a P-type JFET, the threshold voltage is positive and the JFET is in the off-state when the gate-source voltage is more positive than the (positive) threshold voltage. A P-type JFET is a JFET in which the first doping type is a P-type, so that the channel regions 13, the source regions 12, the drift region 11, the drain region 14, and the optional buffer region 15 are P-type regions and the gate regions 21 are N-type regions. Thus, a P-type JFET is in the off-state when the gate-source voltage is positive and has a magnitude that is higher than the magnitude of the threshold voltage. A P-type JFET is in the on-state when the gate-source voltage is less positive than the threshold voltage.

A doping profile of the channel regions 13 affects the characteristic of the JFET in various ways. The "doping profile" of a channel region 13 is defined by the spatial distribution of the doping concentration in the respective channel region 13.

In particular, the doping profile of the channel regions 13 may affect the threshold voltage explained before. Furthermore, the doping profile of the channel regions 13 may affect the on-resistance of the JFET. In the on-state of the JFET, a current can flow between the source regions 12 and the drain region 14 when a voltage different from zero is applied between the source node S (connected to the source regions 12) and a drain node D (connected to the drain region 14). The on-resistance is the electrical resistance of the JFET between the source and drain nodes S, D when the JFET is in the on-state.

Forming channel regions of a JFET may include epitaxially growing a semiconductor layer which is in-situ doped during the epitaxial growth process, and forming the gate trenches that define the mesa regions therebetween. In-situ doping an epitaxial layer, however, may result in relatively high fluctuations of the doping concentration from epitaxial growth process to epitaxial growth process. One example of a method for forming the channel regions 13 that avoids such fluctuations that may result from in-situ doping during an epitaxial growth process is explained in the following.

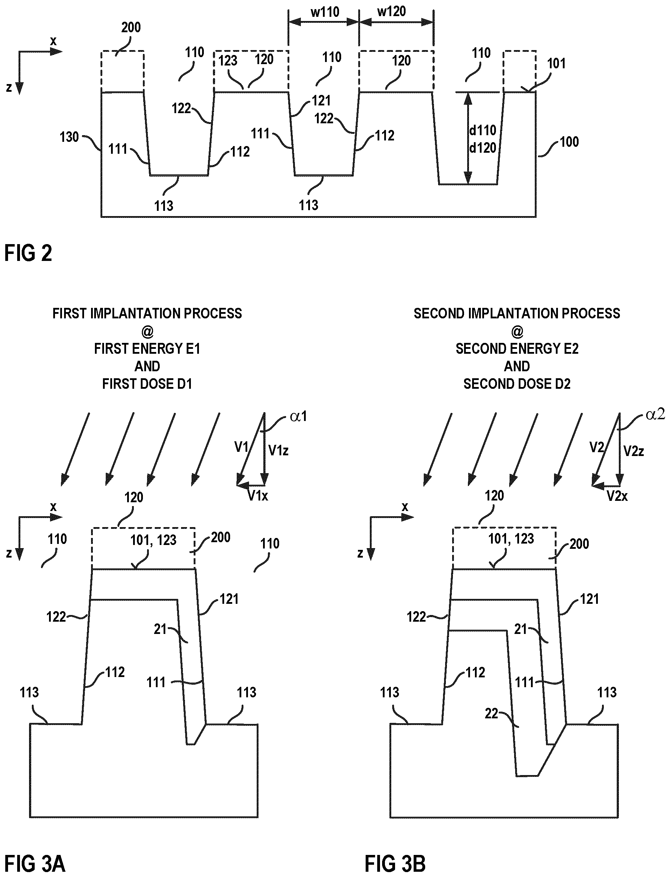

Referring to Figure 2, the method includes forming the mesa regions 120 in a semiconductor layer 130 of the semiconductor body 100. According to one example, the semiconductor layer 130 has a basic doping of the first doping type. According to one example, the semiconductor layer 130 is an epitaxial layer and the basic doping is formed by in-situ doping the epitaxial layer during the epitaxial growth process. Forming the mesa regions 120 includes forming the gate trenches 110 in a first surface of the semiconductor layer 130, which is the first surface 101 of the semiconductor body 100. According to one example, a doping concentration of the basic doping is lower than $5E15$ cm$^{-3}$, in particular, lower than $2E15$ cm$^{-3}$. According to one example, a doping concentration of the basic doping is higher than $5E14$ cm$^{-3}$.

Forming the gate trenches 110 may include an etching process, such as an anisotropic etching process using an etch mask 200 formed above the first surface 101. The etch mask 200, in a conventional way, defines the size in lateral directions and the position in lateral directions of the individual gate trenches 110.

Each of the gate trenches 110 has a first sidewall 111, a second sidewall 112 opposite the first sidewall 111 in the first lateral direction x, and a bottom 113. Dependent on the specific type of etching process that is used for forming the gate trenches 110, the gate trenches 110 can be formed to have essentially vertical sidewalls (not illustrated) or tapered sidewalls (as illustrated).

Vertical first and second sidewalls 111, 112 are essentially parallel to each other, so that the gate trenches 110 essentially have the same width along their entire depth. The "depth" of the gate trenches 110 is the dimension of the gate trenches 110 in the vertical direction z of the semiconductor body 100.

Tapered first and second sidewalls 111, 112 are sidewalls, which are tapered relative to the vertical direction z such that the gate trenches 110 narrow towards the trench bottom 130. In other words, the trench width decreases towards the trench bottom 130. A taper angle, which is an angle between the first and second sidewalls 111, 112 and the vertical direction z, is between 1° and 5°, for example.

Each of the mesa regions 120 has a first sidewall 121 and a second sidewall 122 opposite the first sidewall 121 in the first lateral direction x. The two opposite first and second sidewalls 121, 122 of each of the mesa regions 120 are defined by sidewalls of neighboring gate trenches 110 that define the respective mesa region 120. Thus, dependent on the geometry of the sidewalls 111, 112 of the gate trenches 110, the first and second sidewalls 121, 122 can be essentially vertical or can be tapered. Furthermore, each of the mesa regions 120 has a top surface 123, which is a surface that is defined by those sections of the first surface 101 of the semiconductor body 100 that remain after the gate trenches 110 have been formed.

According to one example, forming the channel regions 13 includes implanting dopant atoms of the first doping type into the opposite sidewalls 121, 122 of the mesa regions 120. Implanting the first type dopant atoms into each of the two opposite sidewalls 121, 122 of each mesa region 120 includes at least two implantation processes that are a different from each other with regard to at least one process parameter. According to one example, process parameters of the implantation processes include an implantation energy, which is the energy at which the first type dopant atoms are implanted, and an implantation dose, which is a concentration of implanted first type dopant atoms per area perpendicular to the surface 101. The implantation vector defines the direction in which the first type dopant atoms are implanted into the respective sidewall. The amount of dopant atoms that are implanted into each sidewall 121, 122 is dependent on the implantation dose (which is referenced to the first surface 101), the tilt angle, and the implantation vector. If the implantation vector is changed, for example, the implantation dose may be adapted in order to maintain a desired amount of dopant atoms that are implanted into the sidewalls.

Figures 3A-3B schematically illustrate two different implantation processes in which first type dopant atoms are implanted into the first sidewalls 121 of the mesa regions 120. For the purpose of illustration, only one mesa region 120 and portions of the two neighboring gate trenches 110 that define the mesa region 120 are illustrated in Figures 3A-3B.

In the first implantation process illustrated in Figure 3A, the first type dopant atoms are implanted at a first implantation energy E1 and a first implantation dose D1. In the second implantation process illustrated in Figure 3B, the first type dopant atoms are implanted at a second implantation energy E2 and a second implantation dose D2.

Referring to the above, the first and second implantation processes are different. According to one example, this includes that the first implantation energy E1 is different from the second implantation energy E2 and the first implantation dose D1 is different from the second implantation dose D2. According to one example, the first implantation energy E1 is higher than the second implantation energy E2,

$$E1 > E2 \qquad\qquad (1),$$

and the first implantation dose D1 is lower than the second implantation dose D2,

$$D1 < D2 \qquad\qquad (2).$$

According to one example, the first implantation energy E1 is between 1.5 times and 3 times the second implantation energy E2,

$$1.5 \cdot E2 < E1 < 3 \cdot E2 \qquad\qquad (3),$$

and the first implantation dose D 1 is between 10% and 60% of the second implantation dose,

$$0.1 \cdot D2 < D1 < 0.6 \cdot D2 \qquad\qquad (4).$$

According to one example, the first implantation energy E1 is selected from between 600 keV and 1000 keV, in particular between 700 keV and 900 keV, and the first implantation dose D1 is selected from between $5E11$ cm$^{-2}$ and $4E12$ cm$^{-2}$, in particular between $1E12$ cm$^{-2}$ and $3E12$ cm$^{-2}$.

According to one example, the semiconductor body 100 is a SiC semiconductor body and the first type dopant atoms are N-type dopant atoms such as phosphorus (P) atoms or nitrogen (N) atoms.

Referring to the above, the implantation vector defines the direction in which the implanted dopant atoms move towards the semiconductor body 100 during the implantation process. According to one example, the first implantation process is a tilted implantation process, which is an implantation process in which the implantation vector V1 is tilted (inclined) relative to the vertical direction z. In this example, the first implantation vector V1 which defines the implantation direction in the first implantation process, has a first lateral component V1x different from zero, and a vertical component V1z different from zero. A first tilt angle $\alpha$1 is an angle between the implantation vector V1 and the vertical direction z. The first lateral component V1x has a direction that is parallel to the first lateral direction x and is directed towards the first mesa surface 121. A second lateral component of the implantation vector V1, which has a direction that is parallel to the second lateral direction y, is zero according to one example.

The size of the tilt angle $\alpha$1 is dependent on whether or not an implantation mask, such as mask 200 illustrated in Figure 2, is arranged on top of the first surface 101 in the implantation process. According to one example, the tilt angle $\alpha$1 is selected from between 20° and 30° if there is an implantation mask on top of the first surface 101 and from between 32° and 37° if there is no implantation mask on top of the first surface 101. A thickness of the implantation mask is between 1 micrometer ($\mu$m) and 1.5 micrometers, for example.

According to one example, the second implantation process is a tilted implantation process, so that an implantation vector V2 is tilted relative to the vertical direction z. In this example, the second implantation vector V2 which defines the implantation direction in the second implantation process, has a first lateral component V2x different from zero, and a vertical component V2z different from zero. A second tilt angle $\alpha$2 is an angle between the implantation vector V1 and the vertical direction z. The first lateral component V2x has a direction that is parallel to the first lateral direction x and is directed towards the first mesa surface 121. A second lateral component of the implantation vector V2, which has a direction that is parallel to the second lateral direction y, is zero according to one example. According to one example, the tilt angle $\alpha$2 is selected from between 20° and 25°. According to one example, the tilt angle is the same in the first and second implantation processes, so that $\alpha$1=$\alpha$2.

The first type dopant atoms implanted in the first implantation process form a first implanted region 21 in the mesa region 120. The first implanted region 21 includes first type dopant atoms introduced into the mesa region in the first implantation process. The first type dopant atoms implanted in the second implantation process form a second implanted region 22 in the mesa region 120. The second implanted region 22 includes first type dopant atoms introduced into the mesa region in the second implantation process.

In the example illustrated in Figures 3A and 3B the second implantation energy E2 used in the second implantation process is higher than the first implantation energy E1 used in the first implantation process. Thus, starting from the first sidewall 121, the second implanted region 22 extends deeper into the mesa region 120 than the first implanted region 21.

It should be noted that the order in which the first and second implantation processes are carried out is arbitrary. Thus, the first implantation process can be carried out before the second implantation process (as illustrated in Figures 3A and 3B), or the first implantation process can be carried out after the second implantation process.

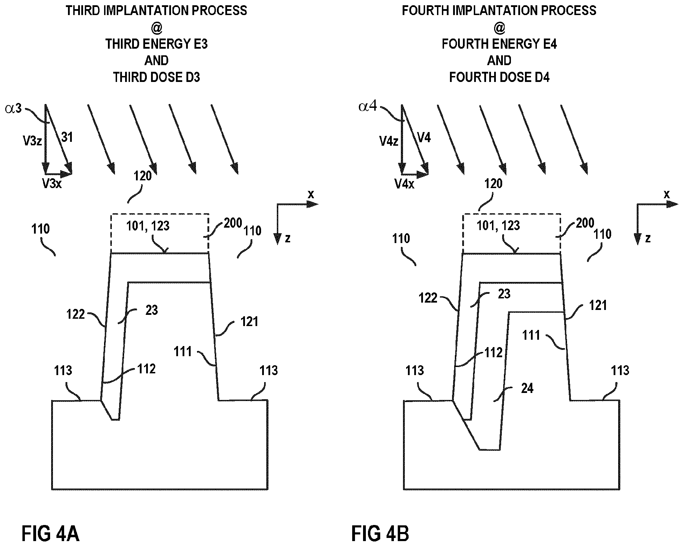

Given the low doping concentration the mesa regions 120 may have before the implantation processes, such as lower than $5E15 \, cm^{-3}$, the relevant amount of dopant atoms that defines the electric properties of the channel regions 13 is introduced into the mesa regions 120 in the implantation processes. As compared to an in-situ doping process, in which dopant atoms are introduced into an epitaxial layer during the epitaxial growth process, the amount of dopant atoms introduced into a grown semiconductor layer, such as semiconductor layer 130 including the mesa regions 120, can be more exactly controlled. Thus, the process explained with reference to Figures 3A-3B and 4A-4B results in channel regions 13 that are less prone to fluctuations of their electrical properties than channel regions that are formed based on only an epitaxially grown semiconductor layer that is in-situ doped during the epitaxial growth process.

According to one example, in the first and second implantation processes, the first dopant atoms are not only implanted into the first mesa region sidewall 121 but are also implanted into the top surface 123. In this example, the top surface 123 is uncovered during the implantation processes. That is, the top surface 123 is not covered by an implantation mask that prevents dopant atoms from being implanted into the top surface 123.

According to another example (illustrated in dashed lines) an implantation mask is formed on top of the top surface 123, wherein the implantation mask prevents dopant atoms from being implanted into the top surface 123. In this example, in the first and second implantation processes, dopant atoms are implanted into the first sidewall 121 but not the top surface 123. According to one example, the implantation mask is the etch mask 200 used for forming the gate trenches 110.

Referring to Figure 2, a trench depth d110 is the dimension of the gate trenches 110 in the vertical direction z, and the trench width w110 is the dimension of the gate trenches 110 in the first lateral direction x. According to one example, the trench depth d110 is selected from a range of between 1 micrometer and 1.5 micrometers. The trench width is selected from between 0.8 micrometers and 2 micrometers, for example. It should be noted that the trench depth d110 equals the depth d120 of the mesa regions 120. A width w120 of the mesa regions is selected from between 0.8 micrometers and 2 micrometers, for example. It should be noted that in examples in which the gate trenches 110 are tapered trenches the trench width w110 of the gate trenches 110 and, equivalently, the width w120 of the mesa regions 120 denotes the respective average width.

According to one example, the tilt angles $\alpha1$, $\alpha2$ in the first and second implantation processes are adapted to the trench width w110 and the trench depth d110 of the gate trenches 110 such that dopant atoms are implanted into the first mesa region sidewall 121 and are essentially not implanted into the trench bottoms 113.

Referring to the above, forming the channel regions 13 includes implanting dopant atoms into each of the first and second opposite sidewalls 121, 122 of the mesa regions 120, wherein implanting the dopant atoms into each of the first and second sidewalls 121, 122 includes two different implantation processes. Thus, implanting the first type dopant atoms into the second sidewalls 122 of the mesa regions includes two implantation processes, a third implantation process at a third implantation energy E3 and a third implantation dose D3 and a fourth implantation process and a fourth implantation energy E4 and a fourth implantation dose D4. The third and fourth implantation processes are schematically illustrated in Figures 4A and 4B. Figure 4A illustrates the third implantation process and Figure 4B illustrates the fourth implantation process.

The third and fourth implantation processes are different. According to one example, this includes that the third implantation energy E3 is different from the fourth implantation energy E4 and the third implantation dose D3 is different from the fourth implantation dose D4. According to one example, the third implantation energy E3 is higher than the fourth implantation energy E4,

$$E3 > E4 \qquad (5),$$

and the third implantation dose D3 is lower than the fourth implantation dose D4,

$$D3 < D4 \qquad (6).$$

Everything explained hereinabove with regard to the first implantation process applies to the third implantation process accordingly, everything explained hereinabove with regard to the second implantation process applies to the fourth implantation process accordingly, and everything explained hereinabove with regard to the relationship between the first implantation process and the second implantation process applies to the relationship between the third implantation process and the fourth implantation process accordingly. Furthermore, according to one example, the third implantation energy E3 at least approximately equals the first implantation energy E1, and the third implantation dose D3 at least approximately equals the first implantation dose D1. Furthermore, according to one example, the fourth implantation energy E4 at least approximately equals the second implantation energy E2, and the fourth implantation dose D4 at least approximately equals the second implantation dose D2.

According to one example, each of the third and fourth implantation processes is a tilted implantation process. According to one example, each of the third tilt angle $\alpha 3$ used in the third implantation process and a fourth tilt angle $\alpha 4$ used in the fourth implantation process is selected from a range of between 20° and 25°. According to one example, the third tilt angle $\alpha 3$ at least approximately equals the first tilt angle $\alpha 1$, and the fourth tilt angle $\alpha 4$ at least approximately equals the second to the angle $\alpha 2$. A third implantation vector V3 used in the third implantation process and a fourth implantation vector V4 used in the fourth implantation process are such that the first type dopant atoms are implanted into the second mesa region sidewalls 122. Thus, lateral components V3x, V4x of the third and fourth implantation vectors V3, V4 are shifted by 180° relative to the lateral components V1x, V2x of the first and second implantation vectors V1, V2.

The first type dopant atoms implanted in the third implantation process form a third implanted region 23 in the mesa region 120. The third implanted region 23 includes first type dopant atoms introduced into the mesa region 120 in the third implantation process. The first type dopant atoms implanted in the fourth implantation process form a fourth implanted region 24 in the mesa region 120. The second implanted region 22 includes first type dopant atoms introduced into the mesa region 120 in the fourth implantation process. In the example illustrated in Figures 4A and 4B, the fourth implantation energy is higher than the third implantation energy. Thus, in this example, the fourth implanted region 24 extends deeper into the mesa region 120 than the third implanted region 23.

It should be noted that the order in which the first, second, third, and fourth implantation processes are carried out is arbitrary. Thus, the first and second implanted regions 21, 22 may already have been formed when the third and fourth implantation processes are carried out or may be formed after the third and fourth implantation processes are carried out. Thus, first and second implanted regions 21, 22 resulting from the first and second implantation processes are not illustrated in Figures 4A and 4B.

Furthermore, it should be noted that implanting dopant atoms in two different implantation processes into each of the two mesa sidewalls 121, 122 is only an example. Basically, the method includes implanting dopant atoms in at least two different implantation processes into each of the two mesa sidewalls 121, 122. Thus, according to another example, the method includes three or more different implantation processes for implanting first type dopant atoms into each of the two mesa sidewalls 121, 122.

According to one example illustrated in Figures 4A and 4B, the first type dopant atoms, in the third and fourth implantation processes, are not only implanted into the second sidewall 122 of each mesa region 120 but are also implanted into the top surface 123. According to another example the first type dopant atoms are essentially only implanted into the second sidewall 122. In this example, an implantation mask (illustrated in dashed lines) is formed on top of the top surface 123. According to one example, the implantation mask is the etch mask 200 used for forming the gate trenches 110.

As explained above, the JFET further includes gate regions 21 adjoining sidewalls 111, 112 and bottoms 113 of the gate trenches 110 and source regions 12. The gate regions 21 may be formed by implanting second type dopant atoms into the sidewalls 111, 112 and the bottoms 113 of the gate trenches 110 before forming the gate electrodes 31. The gate regions 21 may be formed before or after implanting the first type dopant atoms into the mesa regions 120 for forming the channel regions 13.

The source regions 12 are formed by implanting first type dopant atoms via the first surface 101 into the mesa regions 120. According to one example the dopant atoms for forming the source regions 12 are implanted into the first surface 101 before the trenches 110 are formed.

Referring to the above, in the implantation processes for forming the channel regions 13 first type dopant atoms may be implanted via the top surface 123 into the mesa regions 120. According to one example, the implantation dose in the process of forming the source regions 12 is much higher than the implantation doses in the first, second, third, and fourth implantation processes, so that the doping concentration in regions close to the top surfaces 123 of the mesa regions 120 is essentially defined by the implantation dose in the process of forming the source regions 12.

Forming the channel regions 13, the source regions 12, and the gate regions 21 based on the implanted dopant atoms further includes an annealing process in which the implanted dopant atoms are activated. According to one example, forming the JFET includes a single annealing process in which the implanted dopant atoms for forming the channel regions 13, the source regions 12, and the gate regions 21 are activated. According to another example, forming the JFET includes two or more annealing processes to activate the implanted dopant atoms.

According to one example, the drain region 14 is formed by a semiconductor substrate that has the desired doping concentration of the drain region 14. The drift region 11 and the optional buffer region 15 may be formed by epitaxially a growing a semiconductor layer on top of the substrate forming the drain region 14 and in-situ doping the epitaxial layer to achieve the desired doping concentration of the drift region 11 and the optional buffer region 15. The semiconductor layer 130 explained hereinabove in which the gate trenches 110 are formed to define the mesa regions 120 may be formed on top of the epitaxial layer forming the drift region 11.

Referring to the above, a conventional way of defining the doping profiles of channel regions included in mesa regions of a JFET may include intentional or unintentional in-situ doping an epitaxial layer based on which the mesa regions are formed. In contrast to this, in the method explained hereinabove, the doping profiles of the channel regions 13 are defined by implanting first type dopant atoms into the mesa regions 120 such that into each of the two sidewalls 121, 122 first type dopant atoms are implanted in at least two different implantation processes.

(1) The approach of having at least two different implantation processes offers several advantages. (1) In the implantation processes the overall amount of first type dopant atoms implanted into each mesa region 120 can be adjusted more precisely and is more robust against an unintentional in-situ doping process. Thus, the doping concentration of the channel regions 13, which has an effect on the on-resistance and the threshold voltage, can be adjusted more precisely. (2) Implanting the first type dopant atoms in two different implantation processes into each of the sidewalls 121, 122 provides for a smooth doping profile in the first lateral direction x, which can reduce unwanted band-to-band tunneling currents (3) Introducing the first type dopant atoms into the mesa regions by implantation processes makes it possible to vary the doping concentration of the first type dopant atoms in the first lateral direction x. This makes it possible to locally reduce the doping concentration of the first type dopant atoms in those regions in which the gate regions 21, which are regions of the second doping type, are formed. In each case, the gate regions 21 have an effective doping concentration. However, the lower the (absolute) doping concentration of first type dopant atoms in the gate regions 21 the lower the leakage currents that may occur.

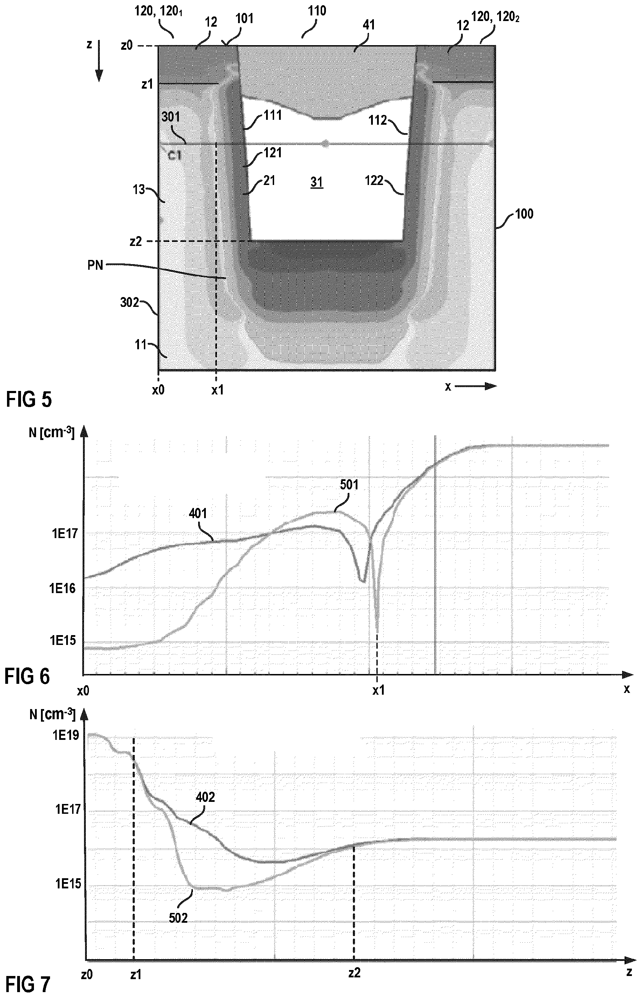

Figure 5 schematically illustrates a portion of the semiconductor body 100 of the JFET that includes a gate trench 110 with a gate electrode 31 and adjoining mesa regions $120_1$, $120_2$. In the first lateral direction x, the portion of the semiconductor body 100 illustrated in Figure 5 extends from the middle of a first mesa region $120_1$ adjoining the first sidewall 111 of the gate trench 110 to the middle of a second mesa region $120_2$ adjoining the second sidewall 112 of the gate trench 110.

In Figure 6, curve 401 illustrates the doping profile, in the first lateral direction x, of one of the channel regions 13 produced in accordance with the method explained hereinabove. More specifically, curve 401 illustrates the doping concentration N of one of the channel regions 13 in the first lateral direction x along line 301 illustrated in Figure 5. In Figures 5 and 6, x0 denotes the position of the middle of the mesa region 120 and x1 denotes the position of the PN junction between the channel region 13 and the gate region 21. It should be noted that curve 401 illustrated in Figure 5 represents the effective concentration. Thus, in the region between the middle of the mesa region 120 and the PN junction curve 401 represents the effective doping concentration of the first doping type, and in the region between the PN junction and the trench sidewall curve 401 represents the effective doping concentration of the second doping type.

In Figure 7, curve 402 illustrates the doping profile of one of the channel regions 13 in the vertical direction z. More specifically, curve 402 illustrates the doping concentration of one of the channel regions 13 in the vertical direction z along line 302 illustrated in Figure 5. In Figures 5 and 7, z0 denotes the position of the first surface 101 of the semiconductor body 100, and z2 denotes the vertical position of the trench bottoms.

The doping profiles illustrated in Figures 6 and 7 relate to a JFET with a mesa region width w120 of about 1 micrometer, $w120 \approx 1 \ \mu m$ and a trench depth d110 of about 1.4 $\mu m$. The channel regions 13 have been formed by implanting first type dopant atoms into each of the first and second sidewalls 121, 122 in two different implantation processes, with an implantation energy of 800 keV and a total wafer implantation dose of $4E12 \ cm^{-2}$ in each of the first and third implantation processes and an implantation energy of 400 keV and a total wafer implantation dose of $1.8E13 \ cm^{-2}$ in the second and fourth implantation processes. The tilt angle was 23° and the dopant atoms were nitrogen (N) atoms in each implantation process.

Referring to the above, a basic doping of the mesa region 120, which is the doping before the implantation processes, may have a doping concentration of less than $5E15 \ cm^{-3}$. In the process the result of which is illustrated in Figures 6 and 7, the basic doping of the mesa regions 120 is $2E15 \ cm^{-3}$. As can be seen from Figure 6, the two different implantation processes with different implantation energies and different implantation doses result in a smooth doping profile in the lateral direction x. That is, for example, a ratio between a maximum doping concentration and a minimum doping concentration is less than 10.

As can be seen from Figure 7, in the middle of the mesa regions 120 (along line 302), a maximum of the doping concentration of dopant atoms of the first doping type may occur in a region close to the first surface 101, which is the region in which the source region 12 is arranged. In the example illustrated in Figure 7, the source region, in the vertical direction z, extends from the first surface 101 (at position z0) to a vertical position z1 at which the source region 12 merges into the channel regions 13. The vertical dimension of the source region 12 is in a range of between 0.2 micrometers and 0.4 micrometers, for example.

For comparison purposes only, curves 501 and 502 shown in Figures 6 and 7 illustrate doping profiles obtained by implanting dopant atoms in only one implantation process with a total wafer dose of 3.1E13 $cm^{-2}$, an implantation energy of 400 keV, and a tilt angle of 23° into each mesa sidewall.

In the channel region 13, the doping concentration, which mainly results from implanting dopant atoms into each sidewall in the two implantation processes explained above, may decrease towards the drift region 11. The doping concentration of the drift region 11 may result from an epitaxial growth process and, as explained above, is in a range of between 1E16 $cm^{-3}$ and 2E16 $cm^{-3}$, for example. In the channel region 13, the doping concentration decreases in the vertical direction z towards the drift region 11. Towards the end of the channel region 13, the doping profile may have a slight dip such that the doping concentration is lower than the doping concentration of the drift region 11. The "end of the channel region 13" is at the position where the channel region 13 merges into the drift region 11 and, in the examples illustrated in Figures 5 and 7, is approximately at the vertical position z2 of the trench bottoms. Comparing curves 402 and 502 illustrated in Figure 7 it can be seen that the dip in the doping profile 402 resulting from the two-step implantation process explained hereinabove is much less significant than a comparable dip that may occur when forming the channel region 13 using a process with only one implantation into each sidewall.

Summarizing the above, forming channel regions of a JFET in mesa regions 120 of a semiconductor body 100 using a two-step implantation process such that first type dopant atoms are implanted into each mesa region sidewall 121, 122 in at least two different implantation processes (resulting overall in at least for implantation processes) results in channel regions 13 that include a relatively exactly defined amount of dopant atoms, and that have smooth doping profiles both in the first lateral direction x and the vertical direction z.

Some of the aspects explained above are briefly summarized in the following with reference to numbered examples.

Example 1. A method, including: forming a plurality of trenches in a first surface of a semiconductor body such that the trenches are separated from each other by semiconductor mesa regions; and forming a channel region of a first doping type in each of the mesa regions, wherein forming the channel region includes implanting first type dopant atoms at least into a first sidewall of the respective mesa region, wherein implanting the first type dopant atoms into the first sidewall includes at least two implantation processes that are different from each other with regard to at least one process parameter.

Example 2. The method according to example 1, wherein the at least one process parameter is selected from the group consisting of: implantation energy; and implantation dose.

Example 3. The method according to example 2, wherein the at least two implantation processes are different with regard to implantation energy and implantation dose.

Example 4. The method according to example 3, wherein the at least two implantation processes include a first implantation process with a first implantation energy and a first implantation dose and a second implantation process with a second implantation energy and a second implantation dose, wherein the first implantation energy is higher than the second implantation energy, and wherein the first implantation dose is lower than the second implantation dose.

Example 5. The method according to example 4, wherein the first implantation energy is between 1.5 times and 3 times the second implantation energy, and wherein first implantation dose is between 10% and 60% of the second implantation dose.

Example 6. The method according to example 4 or 5, wherein the first implantation energy is selected from between 600 keV and 1000 keV, in particular between 700 keV and 900 keV, and wherein the first implantation wafer dose is selected from between 1E12 $cm^{-2}$ and 8E12 $cm^{-2}$, in particular between 2E12 $cm^{-2}$ and 6E12 $cm^{-2}$.

Example 7. The method according to any one of examples 4 to 6, wherein each of the first implantation process and the second implantation process is a tilted implantation process.

Example 8. The method according to any one of examples 1 to 7, wherein forming the channel region further includes: implanting first type dopant atoms into a second sidewall opposite the first sidewall of the respective mesa region, wherein implanting the first type dopant atoms into the first sidewall includes at least two implantation processes that are different from each other with regard to at least one process parameter.

Example 9. The method according to example 8, wherein the at least two implantation processes include a third implantation process with a third implantation energy and a third implantation dose and a fourth implantation process with a fourth implantation energy and a fourth implantation dose.

Example 10. The method according to example 9, wherein the third implantation energy at least approximately equals the first implantation energy, wherein the third implantation doses at least approximately equals the first implantation dose, wherein the fourth implantation energy at least approximately equals the second implantation energy, and wherein the fourth implantation doses at least approximately equals the second implantation dose.

Example 11. The method according to any one of the preceding examples, wherein a width of the mesa region is in a range of between 06 micrometers and 2 micrometers, in particular between 0.6 micrometers and 1.2 micrometers.

Example 12. The method according to any one of the preceding examples, wherein a depth of the mesa region is in a range of between 1 micrometer and 1.8 micrometers, in particular between 1.2 micrometers and 1.8 micrometers.

Example 13. The method according to any one the preceding examples, wherein the mesa regions, before implanting the first type dopant atoms into the first sidewall have a basic doping of the first doping type, wherein a doping concentration of the basic doping is in a range of between 5E14 cm$^{-3}$ and 1E17 cm$^{-3}$.

Example 14. The method according to any one of the preceding examples, further including: implanting first type dopant atoms via the first surface into each of the mesa regions to form source regions.

Example 15. The method according to any one of the preceding examples, further including: implanting second type dopant atoms into sidewalls and bottoms of each of the trenches to form gate regions, and forming a gate electrode in each of the trenches.

## Claims

1. A method, comprising:

   forming a plurality of trenches (110) in a first surface (101) of a semiconductor body (100) such that the trenches (110) are separated from each other by semiconductor mesa regions (120); and
   forming a channel region (13) of a first doping type in each of the mesa regions (120),
   wherein forming the channel region (13) comprises implanting first type dopant atoms at least into a first sidewall (121) of the respective mesa region (120),
   wherein implanting the first type dopant atoms into the first sidewall (121) comprises at least two implantation processes that are different from each other with regard to at least one process parameter.

2. The method according to claim 1,
   wherein the at least one process parameter is selected from the group consisting of:

   implantation energy; and
   implantation dose.

3. The method according to claim 2,
   wherein the at least two implantation processes are different with regard to implantation energy and implantation dose.

4. The method according to claim 3,

   wherein the at least two implantation processes comprise a first implantation process with a first implantation energy and a first implantation dose and a second implantation process with a second implantation energy and a second implantation dose,
   wherein the first implantation energy is higher than the second implantation energy, and
   wherein the first implantation dose is lower than the second implantation dose.

5. The method according to claim 4,

   wherein the first implantation energy is between 1.5 times and 3 times the second implantation energy, and
   wherein first implantation dose is between 10% and 60% of the second implantation dose.

6. The method according to claim 4 or 5,

   wherein the first implantation energy is selected from between 600 keV and 1000 keV, in particular between 700 keV and 900 keV, and
   wherein the first implantation wafer dose is selected from between 1E12 cm$^{-2}$ and 8E12 cm$^{-2}$, in particular between 2E12 cm$^{-2}$ and 6E12 cm$^{-2}$.

7. The method according to any one of claims 4 to 6,
   wherein each of the first implantation process and the second implantation process is a tilted implantation process.

8. The method according to any one of claims 1 to 7, wherein forming the channel region (11) further comprises:

implanting first type dopant atoms into a second sidewall (122) opposite the first sidewall of the respective mesa region (120),

wherein implanting the first type dopant atoms into the first sidewall (121) comprises at least two implantation processes that are different from each other with regard to at least one process parameter.

9. The method according to claim 8,
wherein the at least two implantation processes comprise a third implantation process with a third implantation energy and a third implantation dose and a fourth implantation process with a fourth implantation energy and a fourth implantation dose.

10. The method according to claim 9,

wherein the third implantation energy at least approximately equals the first implantation energy,
wherein the third implantation doses at least approximately equals the first implantation dose,
wherein the fourth implantation energy at least approximately equals the second implantation energy, and
wherein the fourth implantation doses at least approximately equals the second implantation dose.

11. The method according to any one of the preceding claims,
wherein a width (w120) of the mesa region (120) is in a range of between 06 micrometers and 2 micrometers, in particular between 0.6 micrometers and 1.2 micrometers.

12. The method according to any one of the preceding claims,
wherein a depth (d120) of the mesa region (120) is in a range of between 1 micrometer and 1.8 micrometers, in particular between 1.2 micrometers and 1.8 micrometers.

13. The method according to any one the preceding claims,

wherein the mesa regions (120), before implanting the first type dopant atoms into the first sidewall (121) have a basic doping of the first doping type,
wherein a doping concentration of the basic doping is in a range of between $5E14\ cm^{-3}$ and $1E17\ cm^{-3}$.

14. The method according to any one of the preceding claims, further comprising:
implanting first type dopant atoms via the first surface (101) into each of the mesa regions (120) to form source regions (12).

15. The method according to any one of the preceding claims, further comprising:

implanting second type dopant atoms into sidewalls (111, 112) and bottoms (113) of each of the trenches (110) to form gate regions (21), and
forming a gate electrode (22) in each of the trenches (110).

FIG 1

FIG 2

FIRST IMPLANTATION PROCESS
@
FIRST ENERGY E1
AND
FIRST DOSE D1

SECOND IMPLANTATION PROCESS
@
SECOND ENERGY E2
AND
SECOND DOSE D2

FIG 3A

FIG 3B

THIRD IMPLANTATION PROCESS
@
THIRD ENERGY E3
AND
THIRD DOSE D3

FOURTH IMPLANTATION PROCESS
@
FOURTH ENERGY E4
AND
FOURTH DOSE D4

**FIG 4A**

**FIG 4B**

FIG 5

FIG 6

FIG 7

Europäisches
Patentamt
European
Patent Office
Office européen
des brevets

# EUROPEAN SEARCH REPORT

**Application Number**

EP 24 21 9853

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/261117 A1 (WEBER HANS [AT] ET AL) 17 August 2023 (2023-08-17) | 1,2,8-15 | INV. H10D30/01 |
| A | * Fig. 1-4 and correlated text * | 3-7 | H10D30/83 H10D62/17 |
| | ----- | | H10D62/60 |
| X | EP 4 468 361 A1 (INFINEON TECHNOLOGIES AUSTRIA AG [AT]) 27 November 2024 (2024-11-27) | 1,8-15 | |
| A | * Fig. 1 and correlated text * | 3-7 | |
| | ----- | | |

**TECHNICAL FIELDS SEARCHED (IPC)**

H10D

The present search report has been drawn up for all claims

| Place of search | Date of completion of the search | Examiner |
|---|---|---|
| Munich | 9 May 2025 | Melodia, Andrea |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 9853

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | Publication date | Patent family member(s) | Publication date |
|---|---|---|---|
| US 2023261117 A1 | 17-08-2023 | CN 116598334 A | 15-08-2023 |
| | | EP 4228009 A1 | 16-08-2023 |
| | | US 2023261117 A1 | 17-08-2023 |
| EP 4468361 A1 | 27-11-2024 | EP 4468361 A1 | 27-11-2024 |
| | | WO 2024240764 A1 | 28-11-2024 |

EPO FORM P0459

For more details about this annex : see Official Journal of the European Patent Office, No. 12/82